# EUROPÄISCHE PATENTSCHRIFT

(11) **EP 1 778 890 B1**
(45) Veröffentlichungstag und Bekanntmachung des Hinweises auf die Patenterteilung: **12.03.2008**
(21) Anmeldenummer: 05774994.7
(22) Anmeldetag: 26.07.2005
(51) Int. Cl.: C23C 16/44, C23C 16/24, C23C 16/04, C30B 25/00, C30B 29/06, C01B 33/027

(54) **HERSTELLUNGSVERFAHREN FÜR REAKTOR ZUR ZERSETZUNG VON GASEN**
METHOD FOR PRODUCTION OF REACTORS FOR THE DECOMPOSITION OF GASES
PROCEDE DE FABRICATION D'UN REACTEUR POUR LA DECOMPOSITION DE GAZ

(30) Priorität: 10.08.2004 DE 102004038717
(43) Veröffentlichungstag der Anmeldung: 02.05.2007
(73) Patentinhaber: Joint Solar Silicon GmbH & Co. KG, 09599 Freiberg (DE)
(72) Erfinder: MÜLLER, Armin, 09599 Freiberg (DE); SILL, Torsten, 09599 Freiberg (DE)
(74) Vertreter: Rau, Albrecht
(86) Internationale Anmeldenummer: PCT/EP2005/008101
(87) Internationale Veröffentlichungsnummer: WO 2006/018101

(56) Entgegenhaltungen:
- EP-A- 0 134 645
- US-A- 5 260 538
- PATENT ABSTRACTS OF JAPAN Bd. 018, Nr. 427 (C-1235), 10. August 1994 (1994-08-10) & JP 06 127922 A (TONEN CHEM CORP; others: 01), 10. Mai 1994 (1994-05-10)
- PATENT ABSTRACTS OF JAPAN Bd. 1998, Nr. 06, 30. April 1998 (1998-04-30) & JP 10 050635 A (KOKUSAI ELECTRIC CO LTD), 20. Februar 1998 (1998-02-20)

## Beschreibung

Die Erfindung betrifft ein Verfahren zur Herstellung eines Reaktors zur Zersetzung eines Silizium enthaltenden Gases gemäß dem Oberbegriff des Anspruchs 1. Die Erfindung betrifft ferner einen nach dem erfindungsgemäßen Verfahren hergestellten Reaktor. Die Erfindung betrifft des Weiteren die Verwendung des erfindungsgemäßen Reaktors zur Herstellung von Silizium, das als Ausgangsstoff zur Herstellung von Siliziumschmelzen für die Fertigung von Siliziumblöcken oder Siliziumkristallen geeignet ist.

Verfahren zur Herstellung von hochreinem Silizium sind seit langem bekannt. Das aus diesen Verfahren resultierende Prime Poly Silizium besitzt auf Grund seiner langsamen thermischen Abscheidung eine hohe Reinheit und auf Grund seines großen Volumen-/Oberfläche-Verhältnisses nur geringe Oberflächenverunreinigungen, die in die Schmelze eingetragen werden. Nachteilig bei diesen Verfahren ist, dass sie einen sehr hohen spezifischen Energieverbrauch je Kilogramm Reinsilizium und auf Grund der langsamen Abscheidungsrate hohe Fertigungskosten aufweisen.

Ein Verfahren gemäß dem Oberbegriff des Anspruchs 1 ist aus der JP 06127922 A bekannt. Aus der JP 06127922 A ist ein Reaktor zur Herstellung von polykristallinem Silizium bekannt. Der Reaktor umfasst einen Reaktor-Rohling, der mit einer Silizium-Schicht beschichtet ist.

Aus der JP 10050635 A ist eine Vorrichtung bekannt, die einen rohrförmigen Reaktor-Körper umfasst. Die Innenwand des Reaktor-Körpers ist mit einer Silizium-Schicht bedeckt, die eine Beschädigung des Reaktor-Körpers verhindern soll.

Die EP 0 134 645 A1 offenbart ein Verfahren zur innenseitigen Beschichtung eines Reaktor-Rohlings. Der Reaktor-Rohling besteht aus Quarz und ist mit einer Zwischen-Schicht beschichtet, auf welcher eine Schicht aus Silizium-Material aufgebracht sein kann. Die Zwischen-Schicht weist eine gute Adhäsion zu dem Quarz- und dem Silizium-Material auf. Sie kann auch aus Silizium bestehen.

Ein aus der US 5 260 538 bekannter Reaktor zur Herstellung von Polysilizium-Partikeln weist eine Innenfläche auf, die mit einer Siliziumkarbidschicht bedeckt ist. Auf diese Schicht ist wiederum eine Schicht aus Polysilizium aufgebracht.

Aus der DE 10 2004 027 563.7 ist ein energie- und kostensparendes Herstellungsverfahren für Reinsilizium bekannt, bei dem ein Monosilan-Wasserstoff-Gemisch thermisch zersetzt wird und Siliziumpulver entsteht, das anschließend mechanisch verdichtet wird: Das derart entstandene Silizium ist leicht weiterverarbeitbar und weist keine Siliziumoxidverbindungen auf der Oberfläche der Siliziumteilchen auf, so dass die Schmelztemperatur des entstandenen Siliziumpulvers im Bereich der Schmelztemperatur von Silizium liegt. Nachteilig bei diesem Herstellungsverfahren ist, dass sich das aus der Gasphase abgeschiedene Silizium, auch als Chemical Vapor Deposition CVD bezeichnet, auf den Wänden des beheizten Reaktors als Schicht ablagert. Dieser besteht in der Regel aus Glas, insbesondere Quarzglas, das einen im Vergleich zu Silizium unterschiedlichen Wärmeausdehnungskoeffizienten besitzt. Bei einer Abkühlung des Reaktionsbehälters kommt es in Folge der unterschiedlichen Wärmeausdehnungskoeffizienten zu großen Kräften und Spannungen zwischen der abgelagerten Siliziumschicht und dem Quarzglas. Dies führt zu Beschädigungen des Re aktors, insbesondere zu Rissen und Abplatzungen, die in das entstandenen Siliziumpulver gelangen und dieses verunreinigen.

Der Erfindung liegt die Aufgabe zu Grunde, ein Verfahren zur Herstellung eines Reaktors zu schaffen, das den Reaktor wirkungsvoll und einfach vor Beschädigungen durch abgelagerte Siliziumschichten schützt.

Diese Aufgabe wird durch die im kennzeichnenden Teil des Anspruchs 1 und 9 aufgeführten Merkmale sowie durch die Merkmale des Anspruchs 10 gelöst. Der Kern der Erfindung besteht darin, vor der thermischen Zersetzung eines Silizium enthaltenden Gases die Innenwand des Reaktor-Rohlings mit einer Trenn-Schicht zu versehen, welche die Innenwand vor der entstehenden und sich ablagernden Siliziumschicht schützt. Die Trenn-Schicht wird vorzugsweise derart aufgebracht, dass Siliziumpulver in einer leicht flüchtigen Flüssigkeit mit geringer Oberflächenspannung, wie beispielsweise Aceton, dispergiert wird und diese Dispersion anschließend in den Reaktor gefüllt und durch Rotation des Reaktors gleichmäßig an der Innenwand verteilt wird. Durch langsames Verdampfen der leicht flüchtigen Flüssigkeit bildet sich als Trenn-Schicht getrocknetes Siliziumpulver aus, das leicht von der Innenwand entfernbar ist. Die in Folge der thermischen Zersetzung entstehende Siliziumschicht lagert sich auf der Trenn-Schicht ab und dringt in Folge der Trenn-Schicht nicht mehr bis zur Innenwand vor. Das entstandene Siliziumschicht kann sich somit nicht mehr mit der Innenwand des Reaktors verbinden. Die Trenn-Schicht mit der darauf abgelagerten Siliziumschicht kann leicht mechanisch oder chemisch entfernt werden, ohne dass es zu Beschädigungen an der Innenwand des Reaktors kommt.

Weitere vorteilhafte Ausgestaltungen der Erfindung ergeben sich aus den Unteransprüchen.

Zusätzliche Merkmale, Einzelheiten und Vorteile der Erfindung ergeben sich aus der nachfolgenden Beschreibung eines bevorzugten Ausführungsbeispiels an Hand der Zeichnung.

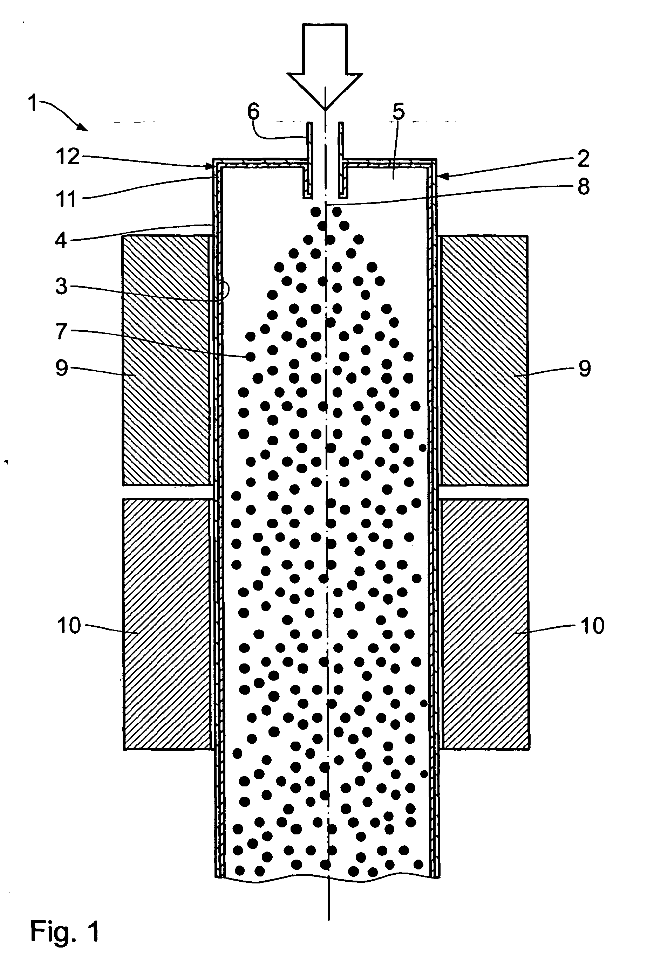

- Fig. 1: zeigt einen Ausschnitt einer Anlage zur Herstellung von Silizium mit einem erfindungsgemäßen Reaktor.

Im Folgenden wird zunächst der Aufbau einer Anlage 1 zur Herstellung von Siliziumpulver beschrieben. Die Anlage 1 weist einen rohrförmigen, vertikal verlaufenden Reaktor-Rohling 2 mit einer Innenwand 3 und einer Außenwand 4 auf, der eine zylindrische Reaktionskammer 5 umschließt. Am oberen Ende des Reaktor-Rohlings 2 ist eine Gas-Zuführ-Leitung 6 angeordnet, die in die Reaktionskammer 5 mündet. Durch die Gas-Zuführ-Leitung 6 kann ein Silizium enthaltendes Gas 7, beispielsweise Monosilan, eingeleitet werden. Der Reaktor-Rohling 2 weist eine Mittel-Längs-Achse 8 auf, um die er drehantreibbar ist. Die obere Hälfte des Reaktor-Rohlings 2 ist von einer ringzylindrischen Heizung 9 umgeben, die den Reaktor-Rohling 2 derart umschließt, dass die Wände 3, 4 der Reaktionskammer 5 auf Temperaturen von über 800°C erwärmt werden können. Die untere Hälfte des Reaktor-Rohlings 2 ist von einer ringzylindrischen Kühl-Einrichtung 10 umgeben, die unmittelbar an die Heizung 9 angrenzt. Im Anschluss an die Kühl-Einrichtung 10 umfasst die Anlage 1 gegebenenfalls weitere Einheiten zur Bearbeitung des gebildeten Siliziumpulvers.

Der Reaktor-Rohling 2 ist an der Innenwand 3 flächig mit einer Trenn-Schicht 11 überzogen. Für die vorliegende Erfindung wird der mit der Trenn-Schicht 11 versehene Reaktor-Rohling 2 als Reaktor 12 bezeichnet.

Zur Herstellung des beschichteten Reaktors 12 muss zunächst der entsprechende Reaktor-Rohling 2 bereitgestellt werden. Dieser besteht vorzugsweise aus Glas, Quarzglas, Graphit, CFC oder SiC. Anschließend wird in die Reaktionskammer 5 des Reaktor-Rohlings 2 ein pulverförmiges Trennmittel eingefüllt und als Trenn-Schicht 11 auf die Innenwand 3 des Reaktor-Rohlings 2 aufgebracht. Vorzugsweise ist das pulverförmige Trenn-Mittel 11 vor dem Aufbringen in einem Dispergiermittel dispergiert. Als Dispergiermittel kann eine leicht verdampfende Flüssigkeit mit einer Verdampfungstemperatur ≤ 800°C, insbesondere ≤ 400°C und besonders vorteilhaft ≤ 100°C bei normalen Umgebungsdruck dienen. In der Praxis haben sich Dispergiermittel bewährt, die Lösungsmittel, insbesondere Aceton, enthalten. Aceton weist eine Verdampfungstemperatur von 56°C bei normalen Umgebungsdruck auf.

Das Trennmittel besteht vorzugsweise zumindest zu einem Teil aus dem gleichen Material aus dem das zu erwartende abgeschiedenen Material besteht. In der Praxis hat sich als Trennmittel ein Pulver aus einer Siliziumverbindung, insbesondere Siliziumpulver bewährt. Die Pulverteilchen des Trennmittels weisen einen mittleren Durchmesser von 0,01 µm bis 100 µm, bevorzugt 0,02 µm bis 20 µm und besonders bevorzugt 0,1 µm bis 10 µm auf.

Zum Aufbringen der Trenn-Schicht 11 wird der Reaktor-Rohling 2, in dessen Reaktionskammer 5 die leicht flüchtige Flüssigkeit mit dispergiertem Siliziumpulver eingefüllt ist, um seine Mittel-Längs-Achse 8 in Rotation versetzt. In Folge der Zentrifugalkraft wird die Aufschlämmung aus Siliziumpulver und der leicht flüchtigen Flüssigkeit gleichmäßig an der Innenwand 3 des rotierenden Reaktor-Rohlings 2 verteilt. Durch das langsame Verdampfen der leicht flüchtigen Flüssigkeit bildet sich die Trenn-Schicht 11 aus, die an die Innenwand 3 des Reaktor-Rohlings 2 antrocknet. Die Trenn-Schicht 11 weist eine Dicke von 10 µm bis 5000 µm, bevorzugt 20 µm bis 500 µm und besonders bevorzugt 30 µm bis 200 µm auf. Es ist auch möglich, den Reaktor-Rohling 2 aus der Anlage 1 für die Aufbringung der Trenn-Schicht 11 zu entfernen und in horizontaler Lage in Drehungen zu versetzen, damit sich die Aufschlämmung gleichmäßig auf der Innenwand 3 verteilt. Das Aufbringen der Trenn-Schicht 11 kann auch durch elektrostatischen Auftrag oder durch Aufsprühen einer Dispersion erfolgen.

Der mit der Trenn-Schicht 11 versehene Reaktor-Rohling 2 wird als Reaktor 12 zur Herstellung von Silizium, das als Ausgangsstoff zur Herstellung von Siliziumschmelze für die Fertigung von polykristallinen Siliziumblöcken oder Siliziumkristallen geeignet ist, in der Anlage 1 verwendet. Für eine detaillierte Beschreibung der Herstellung von Siliziumpulver aus einem Silizium enthaltenden Gas, beispielsweise Monomilan oder Trichlorsilan, wird auf die DE 10 2004 027 563.7 verwiesen. Das in den Reaktor 12 eingeleitete, Silizium enthaltende Gas 7 wird unter Bildung von Siliziumpulver thermisch zersetzt. Mittels CVD lagert sich zumindest teilweise eine Siliziumschicht auf der Oberfläche der Trenn-Schicht 11 ab.

Nach einer bestimmten Verwendungsdauer des Reaktors 12 muss dieser gereinigt und die Trenn-Schicht 11 mit der darauf abgelagerten Siliziumschicht entfernt werden. Dies erfolgt vorzugsweise mechanisch, da die Trenn-Schicht 11 relativ lose mit der Innenwand 3 verbunden ist, wohingegen die abgelagerte Siliziumschicht relativ fest mit der Trenn-Schicht 11 verbunden ist. Durch das mechanische Entfernen der Trenn-Schicht 11 wird das darauf abgelagerte Siliziumpulver ebenfalls entfernt, ohne dass die Innenwand 3 des Reaktors 12 beschädigt wird. Eine chemische Entfernung z. B. unter Verwendung von Laugen ist ebenfalls möglich. Nach der Reinigung des Reaktors 12 kann der verbleibende Reaktor-Rohling 2 erneut mit einer Trenn-Schicht 11 versehen werden und weiter zur Herstellung von Siliziumpulver verwendet werden. Zur Vergrößerung der Reinigungs-Intervalle des Reaktors 12 kann das Silizium enthaltende Gas 7 zusätzlich von einem Hilfsgas, beispielsweise Wasserstoff, in Form eines Ringstromes umgeben werden, so dass die Ablagerungsrate der entstandenen Siliziumschicht auf der Trenn-Schicht 11 verringert wird. Die Verwendung von Hilfsgas in Form eines Ringstromes ist ebenfalls in der DE 10 2004 027 563.7 detailliert beschrieben.

## Patentansprüche

1. Verfahren zur Herstellung eines Reaktors (12) zur Zersetzung eines Silizium enthaltenden Gases (7), umfassend die folgenden Schritte:
a. Bereitstellen eines im Wesentlichen rohrförmig ausgebildeten Reaktor-Rohlings (2) mit einer Innenwand (3) und einer Außerwand (4), **gekennzeichnet durch**
b. Aufbringen einer ein pulverförmiges Trennmittel enthaltenden Trenn-Schicht (11) zumindest auf die Innenwand (3) des Reaktor-Rohlings (2).

2. Verfahren nach Anspruch 1, **dadurch gekennzeichnet, dass** das Trennmittel vor dem Aufbringen in einem Dispergiermittel dispergiert ist.

3. Verfahren nach Anspruch 1 oder 2, **dadurch gekennzeichnet, dass** der Reaktor-Rohling (2) eine Mittel-Längs-Achse (8) aufweist und zum Aufbringen der Trenn-Schicht (11) um die Mittel-Längs-Achse (8) drehantreibbar ist.

4. Verfahren nach einem der vorangegangenen Ansprüche, **dadurch gekennzeichnet, dass** das Trennmittel zumindest teilweise aus Silizium, insbesondere aus Siliziumpulver besteht.

5. Verfahren nach Anspruch 2, **dadurch gekennzeichnet, dass** das Dispergiermittel eine Flüssigkeit mit einer Verdampfungstemperatur ≤ 800 °C, insbesondere ≤ 400 °C und insbesondere ≤ 100 °C bei normalem Umgebungsdruck ist.

6. Verfahren nach Anspruch 5, **dadurch gekennzeichnet, dass** das Dispergiermittel Aceton enthält.

7. Verfahren nach einem der vorangegangenen Ansprüche, **dadurch gekennzeichnet, dass** die Trenn-Schicht (11) eine Dicke von 10 µm bis 5000 µm, insbesondere 20 µm bis 500 µm und insbesondere 30 µm bis 200 µm aufweist.

8. Verfahren nach einem der vorangegangenen Ansprüche, **dadurch gekennzeichnet, dass** das Trennmittel Pulverteilchen mit einem mittleren Durchmesser von 0,01 µm bis 100 µm, insbesondere 0,02 µm bis 20 µm und insbesondere 0,1 µm bis 10 µm aufweist.

9. Reaktor (12) zur Zersetzung eines Silizium enthaltenden Gases (7), **dadurch gekennzeichnet, dass** der Reaktor nach dem Verfahren gemäß einem der Ansprüche 1 bis 8 hergestellt ist.

10. Verwendung eines Reaktors (12) zur Herstellung von Silizium, das als Ausgangsstoff zur Herstellung von Siliziumschmelzen für die Fertigung von Siliziumblöcken oder Siliziumkristallen geeignet ist, umfassend die folgenden Schritte:
a. Bereitstellen eines nach dem Verfahren gemäß einem der Ansprüche 1 bis 8 hergestellten Reaktors (12),
b. Einleiten eines Silizium enthaltenden Gases (7) in den Reaktor (12),
c. thermisches Zersetzen des Gases (7) unter Bildung von Silizium,
d. Ablagerung zumindest eines Teils des entstandenen Silizium als Siliziumschicht auf der Trenn-Schicht (11), und
e. Entfernen der Trenn-Schicht (11) und des darauf abgelagerten Siliziums.

## Claims

1. Method for manufacturing a reactor (12) for separating a gas (7) containing silicon, comprising the following stages:
a. provision of a substantially tubular reactor blank (2) with an inner wall (3) and an outer wall (4), **characterised by** the
b. application of a separating layer (11) containing a powdery separating medium, at least onto the inner wall (3) of the raw form of the reactor (2).

2. Method according to claim 1, **characterised in that** the separating medium is dispersed in a dispersant before being applied.

3. Method according to claim 1 or 2, **characterised in that** the raw form of the reactor (2) has a central longitudinal axis (8) and can be rotatably driven about the central longitudinal axis (8) to apply the separating layer (11).

4. Method according to any one of the preceding claims, **characterised in that** the separating medium consists at least partially of silicon, particularly silicon powder.

5. Method according to claim 2, **characterised in that** the dispersant is a liquid with an evaporation temperature of ≤ 800° C, in particular ≤ 400° C and in particular ≤ 100° C at normal ambient pressure.

6. Method according to claim 5, **characterised in that** the dispersant contains acetone.

7. Method according to any one of the preceding claims, **characterised in that** the separating layer (11) has a thickness of 10 µm to 5000 µm, particularly 20 µm to 500 µm and particularly 30 µm to 200 µm.

8. Method according to any one of the preceding claims, **characterised in that** the powder particles of the separating medium have an average diameter of 0.01 µm to 100 µm, particularly 0.02 µm to 20 µm and particularly 0.1 µm to 10 µm.

9. Reactor (12) for separating a gas (7) containing silicon, **characterised in that** the reactor is manufactured in accordance with the method according to any one of claims 1 to 8.

10. Use of a reactor (12) for manufacturing silicon that is suitable as a raw material for manufacturing silicon melts for the production of silicon blocks or silicon crystals, comprising the following stages:
a. provision of a reactor (12) produced in accordance with the method according to any one of claims 1 to 8,
b. supply of a gas (7) containing silicon into the reactor (12),
c. thermal separation of the gas (7) with the formation of silicon,
d. deposition of at least part of the resulting silicon as a silicon layer on the separating layer (11), and
e. removal of the separating layer (11) and the silicon deposited thereon.

## Revendications

1. Procédé de fabrication d'un réacteur (12) pour la décomposition d'un gaz (7) contenant du silicium, comportant les étapes suivantes :
a. Mise en place d'un châssis de réacteur (2) essentiellement tubulaire avec une paroi interne (3) et une paroi externe (4), **caractérisé par**
b. L'application d'une couche séparatrice (11) contenant un agent séparateur sous forme de poudre, du moins sur la paroi interne (3) du châssis de réacteur (2).

2. Procédé selon la revendication 1, **caractérisé en ce que** l'agent séparateur est dispersé dans un agent de dispersion avant l'application.

3. Procédé selon la revendication 1 ou 2, **caractérisé en ce que** le châssis de réacteur (2) présente un axe longitudinal central (8) et qu'il peut être mis en rotation autour de l'axe longitudinal central (8) pour l'application de la couche séparatrice (11).

4. Procédé selon l'une des revendications précédentes, **caractérisé en ce que** l'agent séparateur est, du moins partiellement, en silicium, tout particulièrement en poudre de silicium.

5. Procédé selon la revendication 2, **caractérisé en ce que** l'agent de dispersion est un liquide avec une température d'évaporation ≤ 800°C, en particulier ≤ 400°C et tout particulièrement ≤ 100°C en pression ambiante normale.

6. Procédé selon la revendication 5, **caractérisé en ce que** le produit de dispersion contient de l'acétone.

7. Procédé selon l'une des revendications précédentes, **caractérisée en ce que** la couche séparatrice (11) présente épaisseur de 10 µm à 5000 µm, en particulier de 20 µm à 500 µm et tout particulièrement de 30 µm à 200 µm.

8. Procédé selon l'une des revendications précédentes, **caractérisée en ce que** l'agent séparateur présente des grains de poudre d'un diamètre moyen de 0,01 µm à 100 µm, en particulier de 0,02 µm à 20 µm et tout particulièrement de 0,1 µm à 10 µm.

9. Réacteur (12) pour la décomposition d'un gaz (7) contenant du silicium, **caractérisé en ce que** le réacteur est fabriqué selon le procédé conforme à l'une des revendications 1 à 8.

10. Utilisation d'un réacteur (12) pour la fabrication de silicium, qui est approprié comme substance de base pour la fabrication de fusion de silicium pour la production de blocs de silicium ou de cristaux de silicium, comportant les étapes suivantes :
a. Mise en place d'un réacteur (12) fabriqué selon le procédé conforme à l'une des revendications 1 à 8
b. Introduction d'un gaz (7) contenant du silicium dans le réacteur (12)
c. Décomposition thermique du gaz (7) par formation de silicium,
d. Dépôt, du moins d'une partie, du silicium formé en couche de silicium sur la couche séparatrice (11) et
e. Enlèvement de la couche séparatrice (11) et du silicium qui s'est posé dessus.
